**Europäisches Patentamt**

(19) **European Patent Office**

**Office européen des brevets**

(11) Publication number: **0 307 906 B1**

(12) # EUROPEAN PATENT SPECIFICATION

(45) Date of publication of patent specification:
28.08.91 Bulletin 91/35

(51) Int. Cl.⁵: **H01J 37/304, H01J 37/317**

(21) Application number: **88115117.9**

(22) Date of filing: **15.09.88**

(54) **Compensating eddy current effects in charged particle beam systems.**

(30) Priority: **16.09.87 JP 231804/87**

(43) Date of publication of application:
**22.03.89 Bulletin 89/12**

(45) Publication of the grant of the patent:
**28.08.91 Bulletin 91/35**

(84) Designated Contracting States:
**DE FR GB**

(56) References cited:
EP-A- 0 148 784
US-A- 4 362 942
JOURNAL OF VACUUM SCIENCE &
TECHNOLOGY B, Microelectronics Proces-
sing and Phenomena, vol. 5, 1987, American
Vacuum Society, New York YOSHIKAWA et al.
"A high dose and high accuracy variable
shaped electon beam exposure system for
quartermicron device fabrication"

(73) Proprietor: **FUJITSU LIMITED**
**1015, Kamikodanaka Nakahara-ku**
**Kawasaki-shi Kanagawa 211 (JP)**

(72) Inventor: **Yasuda, Hiroshi c/o Fujitsu Limited**
**Patent Department 1015 Kamikodanaka**
**Nakahara-ku**
**Kawasaki-shi Kanagawa 211 (JP)**
Inventor: **Suzuki, Masahiko c/o Fujitsu Limited**
**Patent Department 1015 Kamikodanaka**
**Nakahara-ku**
**Kawasaki-shi Kanagawa 211 (JP)**

(74) Representative: **Sunderland, James Harry et**
**al**
**HASELTINE LAKE & CO Hazlitt House 28**
**Southampton Buildings Chancery Lane**
**London WC2A 1AT (GB)**

## Description

The present invention relates to the compensation of eddy current effects in charged particle beam systems, for example beam exposure systems, and more particularly to method and means for compensation of distortion caused by eddy currents induced by leakage flux of a magnetic lens of a beam exposure system.

Beam exposure systems, for example using electron beam exposure and/or ion beam implantation apparatus, are widely used in modern semiconductor manufacture. As the integration scale of integrated circuits (ICs) increases, the requirements for fine patterning on a large area are also increasing. Since it is difficult to maintain sharp beam focusing over a wide scanning area, a pattern to be exposed on a chip is divided into a plurality of fields, and after one field has been exposed, a stage carrying the chip is slid to bring a next field to an exposure position. In this way each of the fields is exposed in turn to complete the exposure of the entire chip pattern. The size of field which can be scanned by a beam becomes smaller as the required pattern accuracy increases.

Recent ICs require extremely fine patterns, so the size of field is reduced, in order to obtain maximum sharp focusing. On the other hand chip size to be exposed is becoming larger. For example, a pattern of a large-scale integrated circuit (LSI) — one centimetre square — is divided into fields one millimetre square. Therefore one hundred step-and-expose steps are necessary to expose on chip pattern. This increases the time needed to expose the chip and decreases the throughput of the beam exposure system. Such a tendency is becoming still more serious in recent LSI manufacture.

With a view to overcoming or mitigating this problem, embodiments of the present invention provide for the use of a continuously moving stage system, which can irradiate a beam over a field while a stage carrying a substrate is moving. In such a continuously moving stage system, or continuous exposure system, a problem arises, namely the eddy current problem explained below, which has not been met with in prior systems. This is because in the usual step and repeat system the stage is stationary while beam exposure is carried out, and while the stage is moving the beam is cut off. Hence no eddy currents arise while the beam is irradiating the substrate.

There have been proposed systems in which a stage is moved while an electron beam is irradiating a substrate to expose a large pattern. In such prior systems, the eddy current problem was not so serious, because in such a system, the bore of a magnetic lens through which the electron beam emerges is designed to be small so as to reduce the leakage flux as much as possible, and the focal length of the magnetic lens could be chosen longer than in a step and repeat system, so that the working distance, i.e. the gap between the lens and the stage, is larger. Accordingly the leakage flux at the position of the stage was not so strong. But since the scanning field of this type of system is very narrow, the throughput is not so good. Further details of such a system can be seen for example in US-A-4362942 of H. Yasuda, or "A high dose and high accuracy variable shaped electron beam exposure system for quartermicron device fabrication" by R. Yoshihara et al, J. Vac. Technol. B5(1), January/February 1987, American Vacuum Society.

If on the other hand, the stage of a step and repeat system is moved while the beam is irradiating the substrate, the problem of eddy currents occurs, because the bore of the magnetic lens is designed large to obtain a wide scanning field, and the working distance is short compared with that in the continuously moving exposure system, in order to maintain high resolution. Therefore leakage flux from the magnetic lens cannot be neglected, and the electron beam is caused to deviate by eddy currents.

The invention provides a method and means of overcoming the deviation of a charged particle beam caused by eddy currents due to leakage flux from a magnetic lens in a charged particle beam exposure system according to claims 1, and 3 and 4.

An embodiment of the present invention provides a system in which a beam can be irradiated onto a substrate while a stage carrying the substrate is moving, using a much wider scanning field than previous continuous exposure systems. The scanning field of such an embodiment of the present invention is comparable to that of a step and repeat system.

Embodiments of the present invention can also provide for an increase in throughput of a charged particle beam exposure system.

Deviation of a charged particle beam due to eddy currents varies at each point on the stage, and the deviation depends on the speed and direction of movement of the stage carrying the substrate. But once the stage is determined, the ratio or proportional constant of beam deviation to velocity of the stage is fixed as a specific value at each point on the stage. So, for an embodiment of the present invention, the deviation of the beam at each point on the stage is measured in advance for each movement of the stage in X and Y directions, and the proportional constant of the deviation at each point on the stage is memorized in a memory device. Usually, the variation of the proportional constant over the stage is very small and mild, so in most cases it can be considered as a constant over the major part of the stage.

When exposure and movement of the stage begin, position and velocity of the stage are measured in real time. A correction signal to compensate the deviation is obtained by multiplying the velocity of the stage and the proportional constant for each point of the stage. The compensation signal is superposed on a deflection signal supplied to X and Y deflectors of the beam exposer, so that the effect of eddy currents is compensated.

Embodiments of the invention will now be described in more detail, by way of example, with reference to the accompanying drawings, in which :

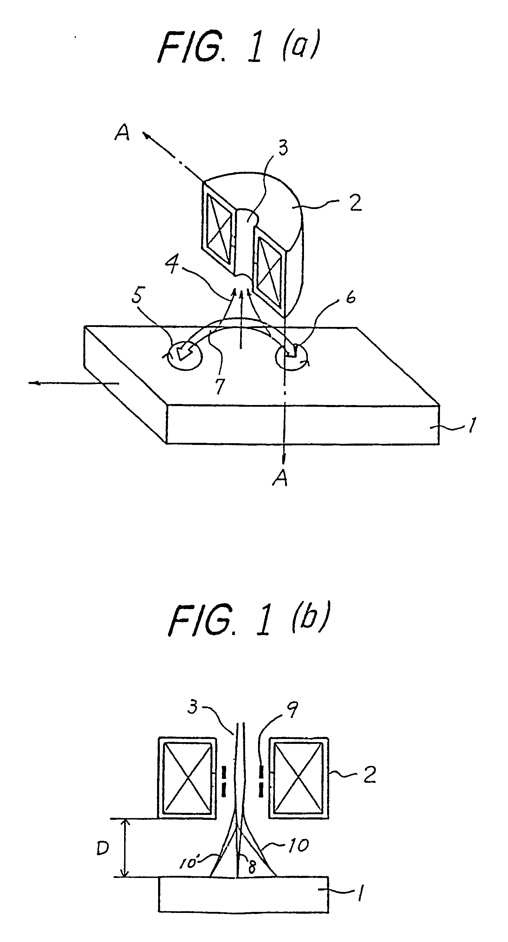

Figs. 1(a) and 1(b) are schematic diagrams illustrating how an eddy current appears, caused by leakage flux of a magnetic lens and movement of a stage, and how it disturbs a charged particle beam ;

Fig. 1(a) is a partial cutaway view of an electron beam exposer illustrating a portion relevant to the present invention ; and

Fig. 1(b) is a cross-sectional view of the device of Fig. 1(a) in a plane including a chained line AA of Fig. 1(a), illustrating how an electron beam is caused to deviate by eddy currents ;

Fig. 2 is a block diagram illustrating in outline the principle used in an embodiment of the present invention to compensate for the effects of eddy currents ;

Fig. 3 is a block diagram of an electron beam exposure system in which the effects of eddy currents are compensated by means of an embodiment of the present invention ;

Fig. 4 is a further detailed circuit diagram illustrating a correction generator part of Fig. 3, to explain the operation of the circuit ;

Fig. 5 shows schematically a portion of an electron beam exposer to illustrate a method for measuring the effects of eddy currents ; and

Fig. 6 shows an example of a test pattern used for measuring the effects of eddy currents.

Throughout the drawings the same or like reference numerals designate similar or corresponding parts.

In the following detailed disclosure, embodiments of the invention will be described with reference to an electron bean exposer, but it will be obvious that the invention can be easily applied to other charged particle beam apparatus, for instance ion beam implantation equipment.

Fig. 1(a) is a partially cutaway perspective view of an electron beam exposer, schematically illustrating a portion relevant to the eddy current problem. A stage 1 carries a substrate (not shown) and is moved in X and Y directions. The stage comprises various support and slide (movement) mechanisms, but for the sake of simplicity stage 1 is represented by a metal plate. 2 is a magnetic lens for focussing the electron beam (not shown) on the substrate. Usually, the magnetic lens 2 is magnetically sealed to prevent leakage flux. But it is impossible to seal the magnetic field off perfectly, because the magnetic lens is provided with a bore 3 through which the electron beam passes. Hence, some magnetic field leaks out from the magnetic lens 2. In order to obtain a sharp focus of the electron beam on the substrate, the focal length of the magnetic lens must not be too long. So the working distance D, i.e. the distance between the magnetic lens 2 and stage 1, cannot be made too great, and usually it is for example about 5 mm. It is impossible for state-of-the-art technology to provide a perfect magnetic seal within the space of the working distance, to protect the stage from the leakage flux.

So, as shown in Fig. 1(a), some leakage flux 4 appears, and crosses (cuts) stage 1. If stage 1 moves to the left for example, as shown by an arrow, a portion 5 appears on stage 1 where the leakage flux increases, and at the same time another portion 6 appears where the leakage flux decreases as stage 1 moves. These changes in flux density generate eddy currents schematically shown by arrowed circles at the portions 5 and 6 respectively. Since the directions of flow of the eddy currents at portions 5 and 6 are opposite to each other, an induced magnetic flux appears from the portion 6 to the portion 5 as shown by a broad arrow 7 in Fig. 1(a). This induced magnetic flux 7 crosses the path of the electron beam, and it causes a deviation of the electron beam path.

Fig. 1(b) shows schematically a cross-sectional view of the device of Fig. 1(a), cut along the plane including a chained line AA in Fig. 1(a). In the Figure, the reference numeral 8 designates an electron beam generated when stage 1 is stationary. The electron beam 8 can be precisely deflected by deflectors 9. But if the stage is moved, corresponding to the movement of the stage in Fig. 1(a) (at right angles out of the plane of the drawing, towards the reader) induced magnetic flux 7 (not shown) appears at right angles to the plane of the drawing. So, the electron beam 8 is deviated by this induced magnetic flux as shown at 10. It will be apparent that if stage 1 is moved in the opposite direction, the electron beam 8 will be deviated to the opposite side 10' in Fig. 1(b).

Such deviation of the beam causes error or distortion in the exposed pattern irradiated by the electron beam 8.

As can be understood from the above description, the deviation of the electron beam caused by the induced magnetic field occurs approximately laterally of the movement of the stage, and the amount of the deviation is proportional to the speed of movement of the stage.

More precisely, such deviation of the beam is not always at right angles to the direction of movement of stage 1 but is generally approximately so. It depends on the structure and material of the stage, the magnetic lens, electron energy, etc. But once these factors are fixed, the deviation of the beam from its normal position, and hence the distortion of the pattern, becomes proportional to the velocity of the stage. The ratio or proportional constant becomes a specific value for each point on the stage.

Such distortion is a new problem which did not appear in prior step and repeat-type systems. According to an investigation by the present inventors using an ordinary step and repeat-type exposure system, the deflection of the electron beam caused by the induced magnetic field due to the leakage flux of the magnetic lens can amount to as much as 0.06 to 0.3 μm. These values are too large to be ignored in precise exposure.

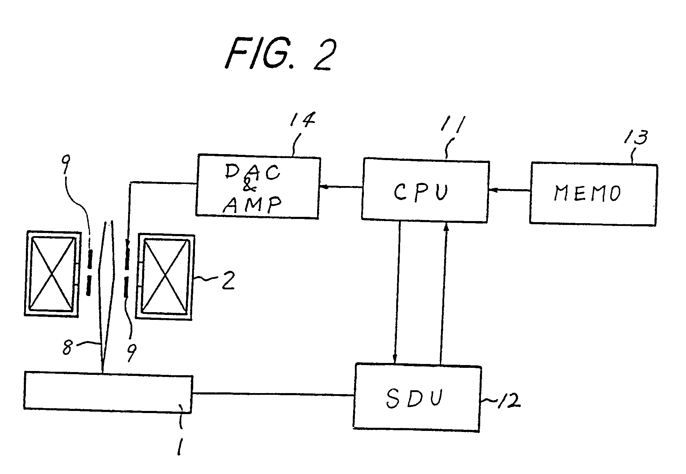

Fig. 2 is a block diagram illustrating in outline the principle used in an embodiment of the present invention to compensate the effects of eddy currents. The system is controlled by a central processing unit (CPU) 11. Stage 1 is driven by a stage driving unit (SDU) 12, which drives stage 1 in X and Y directions under the command of the CPU 11. Signals to determine the position and velocity of stage 1 are given by the CPU 11. At the same time, the actual position and speed of stage 1 are measured by the SDU 12 in real time, and the signals reporting these measured values are fed back from the SDU 12 to the CPU 11. In a memory device (MEMO) 13 are stored the proportional constant of the beam distortion to the eddy current for each position of stage 1, which are measured in advance. The deflection of the electron beam 8 is also controlled by the CPU 11 through a digital-to-analog converter (DAC) and amplifier (AMP) 14, in like manner to that used in conventional electron beam exposure.

When the CPU 11 receives the signals from the SDU 12 reporting the real position and speed of stage 1, it reads out the proportional constant stored in the MEMO 13 corresponding to the position of the stage. The CPU generates a correction signal which is a product of the proportional constant and the velocity of the stage, and the correction signal is superposed on the deflection signal which deflects the electron beam when the effect of the eddy currents is not taken into account. The combined deflection signal, obtained by adding the beam deflection signal and the correction signal, is fed to the beam deflector 9. The distortion of the electron beam due to the eddy currents is thus corrected.

The inventors found in an ordinary step and repeat-type electron beam exposer that there is a time lag of about 20 m sec. between the control signal sent out from the CPU and the real motion of the stage. Such time lag can also be corrected by the above feedback process, because the correction is done for actual position and speed of the stage measured in real time. The correction will become more apparent from the following description of an embodiment of the present invention.

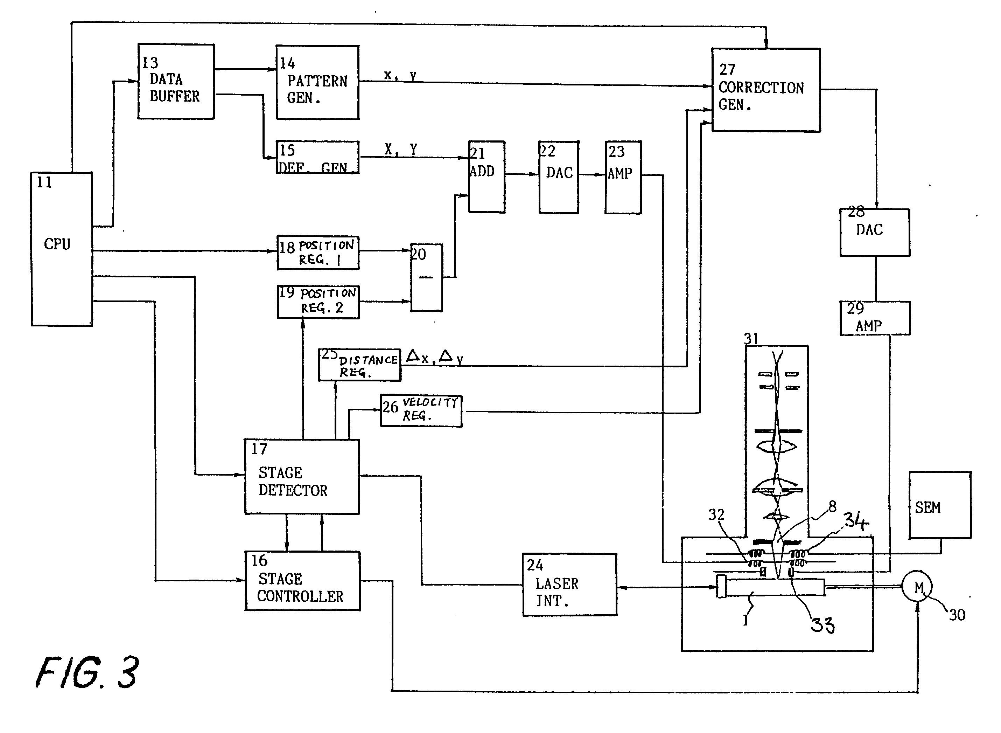

Fig. 3 is a circuit diagram illustrating an embodiment of the present invention applied to an electron beam exposer. A CPU 11 controls the operation of the entire system. An electron beam exposer (EBE) 31 includes a stage 1, which can move in X and Y directions, carrying the substrate (not shown). The EBE 31 comprises a set of main deflectors 32 which mainly deflect the electron beam 8 in X and Y directions, a set of subdeflectors 33 which precisely deflect the electron beam independently of the main deflectors 32, and a set of scanning electron microscope (SEM) deflectors 34 which scan the electron beam 8 in a SEM mode. Recent conventional electron beam exposers are provided with these electrodes, and they are also provided with an electron source, a lens, deflecting electrodes and so on, but since these latter items are not directly relevant to the present invention, their description is omitted for the sake of simplicity.

In order to obtain the highest resolution and accuracy, a pattern of a chip is divided into plurality of fields having a size of, for example, 2 × 2 mm, and each of the fields is further divided into a plurality of subfields having a size of, for example, 100 × 100 μm. In an ordinary step and repeat system, the stage is moved to a field. The main deflector deflects the electron beam to a subfield. The subdeflector 33 deflects the electron beam within the subfield to project (irradiate, expose) a pattern of the subfield. When the subfield is exposed, the main deflector deflects the beam to the next subfield. In this manner all of the subfields in the field are exposed and the stage moves to the next field. In the embodiment of the present invention the stage is moved continuously while the electron beam is irradiating the substrate.

First, the general operation of the system will be described referring to Fig. 3. Stage 1 is driven by a motor 30 and moved in X and Y directions under the control of a stage controller 16, which is commanded by the CPU 11. The actual position of stage 1 and its speed are precisely measured in real time by a stage detector 17 using a laser interferometer 24. A main deflection signal X and Y, which deflects the electron beam to the position of a subfield, and pattern signals x and y, which deflect the electron beam within the subfield to expose the pattern, are generated respectively by a deflection signal generator 15 (DEF GEN) and a pattern generator 14, referring to position data stored in a data buffer 13, under the command of the CPU 11. These signals are respectively fed to the main deflector 32 and the subdeflector 33, via respective digital-to-analog converters (DAC) 22, 28 and amplifiers (AMP) 23, 29. These controls are similar to those in ordinary step and repeat exposure systems. In the present embodiment, however, stage 1 is moving. So, a correction is necessary.

Before explaining the compensation of the effects of eddy currents, correction for movement of the stage will be described. It is achieved with two types of corrections as described below.

The first correction is for correcting the difference between the actual position of stage 1 and its expected position, i.e. the position calculated from the command of the CPU where stage 1 should be positioned. Such difference occurs due to the existence of mechanical tolerance, time lags in the system, hysteresis, and so on. The expected position data of stage 1 is sent out frequently from the CPU 11, and stored in a first position register 18. At the same instant, real position data sent out from the stage detector 17 is stored in a second position register 19. These two data are compared in a comparator 20, and the output of the comparator 20 is fed to an input terminal of an adder 21. To another input terminal of the adder 21 are supplied the main deflection signals X and Y (which are digital signals) sent from the deflection signal generator 15. These two signals are added by the adder 21 to obtain an actual deflection signal which is corrected by the difference between the actual position and the expected position of stage 1. The actual deflection signal is converted into an analog signal by DAC 22, amplified by AMP 23, and supplied to the main deflector 22, to deflect the electron beam 8 to the position of a field.

The second correction is for correcting an error due to the movement of stage 1. Though the position of the stage is measured in real time, the feedback is done intermittently. In practice, the feedback is done each time the main deflector shifts the electron beam from one subfield to the next subfield. By the first correction described above, the electron beam spot will be projected on a correct position at an instant of the feedback, that is at the start point of the subfield, but the beam spot will move continuously since stage 1 is moving continuously. Accordingly, correction is necessary to compensate such movement of the electron beam spot. It is done by shifting the electron beam at the same speed as that of the stage in the direction of movement of stage 1, using the subdeflector 33.

The stage detector 17 outputs velocity signals $V_x$ and $V_y$ which represents the velocity components of stage 1 respectively in X and Y directions. These data are obtained from the time derivative of the position signal, and written in a velocity register 26. The stage detector 17 also outputs distance signals $\Delta_x$ and $\Delta_y$ which respectively represent the distance of movement of stage 1 in X or Y direction, during the time period from the previous feedback to the present instant. If the stage moves at a constant speed, the values of $\Delta_x$ and $\Delta_y$ increase constantly with time. The values of $\Delta_x$ and $\Delta_y$ are written in a distance register 25, and rewritten each time new values are sent out from the stage detector 17. Using these data, the second correction is done in the correction generator 27, and the correction signal is supplied to the subdeflector 33, via the DAC 28 and the AMP 29.

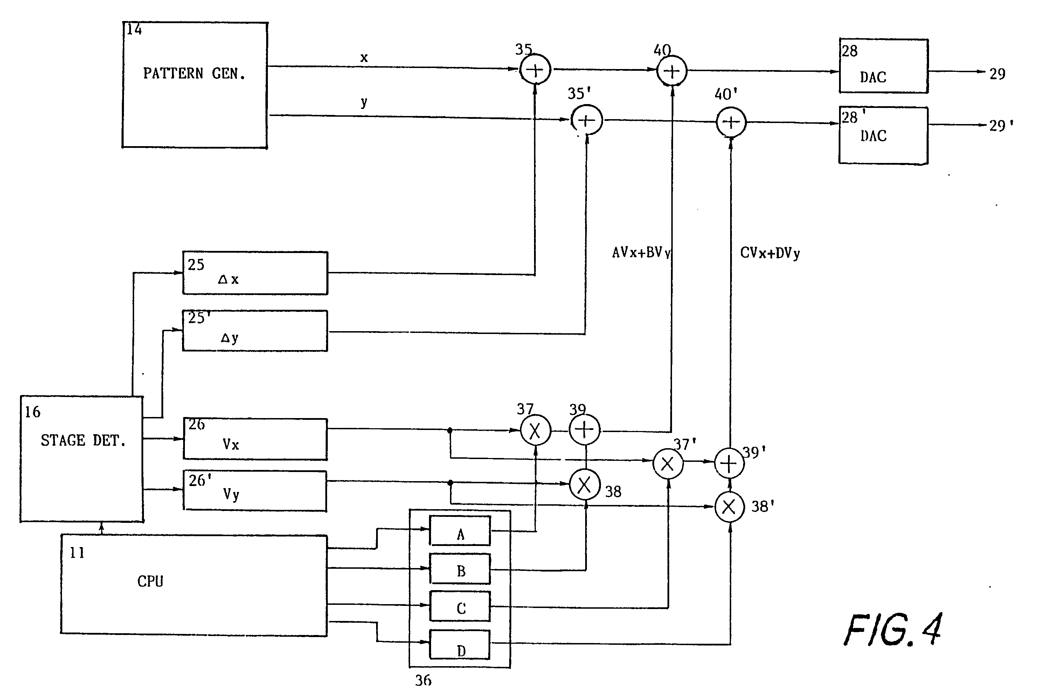

Fig. 4 illustrates details of the circuit relevant to the correction generator 27 in Fig. 3. In this correction generator, the second correction described above, and the correction for the eddy current, are done simultaneously. In the foregoing description, the main deflector, subdeflector and their related wirings were largely referred to in the singular, for the sake of simplicity, but actually they are each composed of a set of deflectors respectively operating in X and Y directions, so that the circuit is composed of a pair of circuits each handling the deflections in X or Y directions respectively. They are shown separately in Fig. 4 and denoted with the same reference numerals and corresponding dashed reference numerals to those of the foregoing Figures.

As has been described before, the electron beam is deflected to a subfield by the main deflector 9. The pattern gererator 14 generates a set of pattern signals x and y, which deflect the beam to a point (x, y) in the subfield to generate a pattern. At each time the pattern signals x and y are sent out from the pattern generator 14, the distance signals $\Delta_x$ and $\Delta_y$ are taken out simultaneously from respective distance registers 25, 25' and added to the pattern signals x, y respectively by the adders 35, 35'. It will be understood that, by this operation, the electron beam on the substrate is shifted in the direction of stage 1 at the same speed as that of the stage. As a result the movement of the beam spot on the substrate due to the movement of the stage is cancelled. This is the second correction described above.

Correction for the effects of eddy currents is carried out as follows. Since, as has been described above, the deflection of the electron beam due to eddy currents is proportional to the velocity of the stage ($V_x$, $V_y$ in X and Y directions), $\delta x$, $\delta y$, the X and Y deflections of the electron beam caused by the eddy currents in X and Y directions can be expressed respectively as :

$$\delta x = A.V_x + B.V_y \quad (1)$$
$$\delta y = C.V_x + D.V_y \quad (2)$$

where, A, B, C and D are proportional constants. These proportional constants are determined by experiment beforehand, and stored in the CPU 11. These values are specific for each particular stage and magnetic lens. So, once these values are determined, they can be used as a specific constant for the EBE. Theoretically, the values of A, B, C and D may vary at each position on stage 1. But in practice the variations of these values are very mild and small over the stage. So, in most cases, especially over the small area of the field, these values can be treated as constant.

The CPU 11 sends out the value of A, B, C and D for the respective positions on the stage, and stores them in respective registers 36. At the same instance, the stage detector 16 outputs the velocity signals $V_x$, $V_y$, and stores them in respective velocity registers 26 and 26'. These operations are done under a command of the CPU 11. Usually, stage 1 is moved at a constant speed, so that the values of $V_x$ and $V_y$ are constant unless the speed is varied. The values of A

and $V_x$ are taken out from respective registers 26, 36, and multiplied together by a first multiplier 37, to give $A.V_x$. Similarly, the values of B and $V_y$ are multiplied together by a second multiplier 38, giving the value of $B.V_y$. These values are added by a first adder 39 to give the value $(A.V_x + B.V_y)$. Similarly, the value $(C.V_x + D.V_y)$ is given by another pair of first and second multipliers 37′, 38′ and another first adder 39′. Those values are the correction factors of equations (1) and (2). The pattern signals which are corrected by the second correction in the adders 35, 35′ are respectively further added to the correction factors $(A.V_x + B.V_y)$ and $(C.V_x + D.V_y)$ by second adders 40, 40′, and sent to respective DACs 28, 28′ and fed to X and Y subdeflectors via respective amplifiers 29, 29′ (not shown). In such a manner, the second correction and the correction for the eddy currents are done simultaneously in the correction generator circuit 27.

Next, the obtaining of the proportional constants A, B, C and D by experiment will be described.

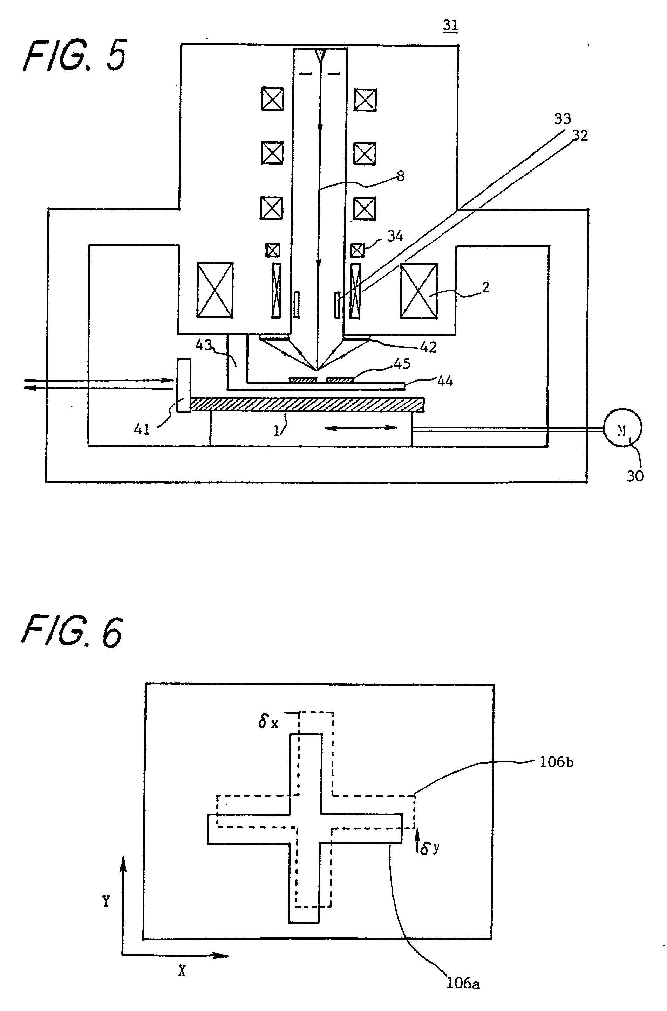

Fig. 5 shows a partially enlarged schematic cross-sectional view of an electron beam exposer having an attachment for measuring the effects of eddy currents. Stage 1 is movable in X and Y directions, driven by a motor 30. The X direction is shown by an arrow in the Figure, while the Y direction is perpendicular to the plane of the Figure. At one edge of stage 1 is provided a mirror 41 which reflects the laser beam from the laser interferometer 24 (see Fig. 3) to give the information of actual position of stage 1. Though they are not shown, stage 1 is also provided with a similar mirror and laser interferometer for the Y direction. The EBE 31 is provided with a magnetic lens 2, main deflector coils 32, subdeflector electrodes 33, and SEM deflector coils 34. Description of other parts of the EBE is omitted, for the sake of simplicity.

Recent electron beam exposers are usually provided with a reflected electron detector 42 which is a kind of semiconductor diode to detect reflected electrons of the incident electron beam 8 or secondary electrons generated by the incident beam 8. One feature of the electron beam exposer used for this embodiment of the present invention is that it is provided with a support arm 43 to support a test substrate 44 parallel to stage 1. The support arm 43 is made of nonmagnetic material, and is detachably fixed to the body of the EBE 31. The design of the support arm 43 may be of any shape, but it is devised to support the test substrate 44 parallel and as close as possible to the top surface of stage 1. In practice a gap of about 1 mm between the test substrate and the top surface of the stage is allowable, without hindrance to the measurement described below. By means of this support arm 43, the test substrate 44 is fixed with regard to the body of the EBE 31 or the magnetic lens 2, regardless of the motion of stage 1.

Using the SEM deflector 34, the electron beam 8 is scanned over the test substrate 44 in a scanning electron microscope mode. On the test substrate 44 is formed a test pattern 45, one example of which is shown in Fig. 6 by a full line. In this example, a test pattern 45, for instance, of a cross mark, is formed for example with gold over the surface of the test substrate 44, which is made, for example, of silicon. The width of each branch of the cross mark may, for example, be 5 µm, the length of each arm 20 µm. The branches are respectively aligned in X and Y directions. Since there is a difference in electron beam reflectivity between the substrate and gold, the quantity of reflected electrons (scattered electrons and secondary electrons are all included therein) collected by the reflected electron collector 42 varies depending on whether or not the electron beam 8 is irradiating the test pattern 45. So, if the signal taken out from the reflected electron detector 42 is fed to the brightness control terminal of a CRT (cathode ray tube, not shown) display device, and the scanning of the CRT is synchronized to the SEM mode scanning of the electron beam exposer, an image of the test pattern 45 appears on the CRT. This is exactly similar to viewing the test pattern with a scanning electron microscope.

Let Fig. 6 be an image of the pattern appearing on the CRT. The magnification of the pattern is adjusted to show the image properly on the CRT by adjusting the amplification factor and scanning width of the electron beam 8. When stage 1 is not moved, the eddy current does not appear, and then the image of the pattern appears as shown by a full line in Fig. 6. When stage 1 is moved, the eddy current appears on stage 1, and it deflects the incident electron beam 8 so that the image on the CRT is shifted as shown by a broken line in Fig. 6, though the test substrate 44 is not moved with stage 1. The shift of the image on the CRT varies with the speed and direction of the movement of stage 1. The shift of the image becomes large at the edge of the stage, but over most of the stage, the variation of the shift is very small and mild, especially over a small area of scanning field, for example the shift can be considered to be almost constant so long as the velocity of the stage is constant.

If the stage is moved in the X direction, the image of the pattern or the CRT shifts mainly in the Y direction as shown in Fig. 6. This is because, as has been explained above with reference to Fig. 1, the incident electron beam 8 is bent almost laterally to the movement of stage 1. Such a shift of the beam spot caused by the eddy currents can easily be measured on the CRT because the size of the test pattern is known. If the displacements of the image in X and Y directions are δx and δy respectively when the stage is moved in the X direction with a constant speed $V_x$, the proportional constants A and C in the equations (1) and (2) can be obtained respectively by

$$A = \delta x/V_x \quad (3)$$
$$C = \delta y/V_x \quad (4).$$

Similarly, the proportional constants B and D can be obtained from the displacement of the image $\delta x'$ and $\delta y'$ (not shown) when the stage is moved in the Y direction with a constant speed $V_y$ by

$$B = \delta x'/V_y \quad (5)$$
$$D = \delta y'/V_y \quad (6).$$

The proportional constants A and D are very small compared to B and C, and the variations of A, B, C, D are very mild and small over a wide area of stage 1. Therefore, they can be considered as constants over a small scanning field of the electron beam 8. If these values at each portion of the stage are memorised in memory means, the CPU can use them and generate a correction signal for cancelling the effect of the eddy currents on the electron beam. The velocities of the stages $V_x$ and $V_y$ are varied according to the operation of the system, but the values of A, B, C, D do not vary, so they are specific constants for the particular stage and magnetic lens(es) involved.

It should be pointed out that in order to apply these proportional constants to the circuit of Figs. 3 or 4, negative values of them, that is -A, -B, -C, -D should be used in order to compensate the deflection of the beam spot due to the eddy current.

A more practical and easy way to obtain the proportional constants A, B, C, D will now be described. Turning back to Fig. 4, it is possible to manually set a value of A, B, C and D to each of registers 36 using a command of the CPU 11. Watching the image of the test pattern on the CRT operated in SEM mode, stage 1 is moved in the X direction with a constant speed $V_x$, 50 mm/sec. for instance. The image is displaced and then if a value is set to the register C, the image is shifted back to some extent in the Y direction. In this way, by varying the setting value of the C register, the image on the CRT can be brought back to the original position where the stage is not moved. The value set in the C register at this time is the required value of the proportional constant C at that position of stage 1. By adjusting the setting value of the A register to compensate for the shift of the image in the X direction, the value of A is obtained. Similarly, the values of B and D are obtained by moving stage 1 in the Y direction with a constant speed $V_y$.

As has been described above, the effects of eddy currents due to the movement of the stage can be compensated. It thus becomes possible to expose a pattern accurately while the stage is moving. This provides for improved throughput of the electron beam exposure system. The compensation of the effects of the eddy currents has been explained with respect to an electron beam exposure system, but it will be obvious that embodiments of the invention can be applied to any charged particle beam exposure system. The methods and apparatuses (systems) described above and embodying the invention may be modified in various ways, for example compensation feedback can be effected using the main deflector, the measurement of position or speed of the stage can be effected in various ways, and the circuit shown in Fig. 4 may be varied while retaining the same feedback effect on the deflection coils.

Embodiments of the present invention provide methods of avoiding or mitigating effects of eddy currents due to leakage flux of a magnetic lens in charged particle beam exposure systems, and systems (apparatuses) which can expose a substrate to a charged particle beam while a stage carrying the substrate is moving. By applying an embodiment of this invention, a step and repeat system can be operated while the stage is moving, so that the throughput of the system is improved. Deviation of the charged particle beam caused by eddy currents is proportional to the velocity of the stage. A proportional constant of the deviation to the velocity of the stage is therefore measured in advance, and a correction term which is a product of the speed of the stage and the proportional constant is fed back to deflector of the charged particle beam. The proportional constant, for example, is obtained from the shift of an image of a test pattern watched on a CRT in a SEM mode, from a first position when the stage is not moved to a second position while the stage is moving with a constant speed.

## Claims

1. A method for compensating effects of eddy currents in a charged particle beam exposure system due to leakage flux from a magnetic lens of the system and motion of a stage of the system carrying a substrate on to which a focused charged particle beam is irradiated while said stage is moving and said beam is being deflected in X and Y directions by pattern signals x, y to deflect the beam to a position (x, y) of a pattern, said method comprising the steps of :

   (a) determining proportional constants between the deviation of the charged particle beam caused by the eddy currents and the velocity of the stage ;

   (b) generating a correction signal which is a negative product of the velocity of the stage and said proportional constants ; and

   (c) superposing said correction signal on said pattern signal, so as to correct said deviation of the charged particle beam.

2. A method according to claim 1, wherein said proportional constants comprise four constants A, B, C and D which are determined by the following relationships :

$$\delta x = A.V_x + B.V_y \quad (1)$$
$$\delta y = C.V_x + D.V_y \quad (2)$$

where $\delta x$, $\delta y$ are the shifts of the charged particle beam spot due to the eddy currents respectively in X and Y directions on said substrate, and $V_x$, $V_y$ are the velocity components of said stage in X and Y directions respectively, and said step (a) comprises the steps of :

(a-1) supporting a test substrate, having a test pattern, in a position parallel to the top surface of said stage and as close as possible to but separated from said stage, so that said test substrate is fixed relative to said magnetic lens of said charged particle beam exposure system, regardless of the motion of said stage ;

(a-2) showing an image of said test pattern on a cathode ray tube by scanning electron mode operation of said charged particle beam exposure system ;

(a-3) moving said stage in X or Y directions with a constant speed $V_x$, $V_y$ respectively ; and

(a-4) determining the values of $\delta x$ and $\delta y$ in said equations (1) and (2) from the shift of said image from a first image position when the stage is not moving to a second image position when the stage is moving.

3. A charged particle beam exposure system, in which the effects of eddy currents due to leakage flux from a magnetic lens of the system and motion of a stage of the system carrying a substrate on which a focused charged particle beam is irradiated while said stage is moving are compensated, said system comprising :

deflecting means for deflecting said charged particle beam in accordance with a pattern, by means of pattern signals ;

detecting means for detecting the position and velocity of said stage in real time, and sending out position data and velocity data ;

memory means storing proportional constants between the deviation of the charged particle beam caused by the eddy currents and the velocity of the stage ;

correction generating means for generating correction signals which are a negative product of said proportional constants and said velocity data ; and

feedback means for feeding back said correction signals to said deflecting means.

4. A charged particle beam exposure system, in which compensation is provided for the effects of eddy currents due to leakage flux of a magnetic lens of the system and motion of a stage of the system carrying a substrate on to which a focused charged particle beam is irradiated, said beam being deflected in X and Y directions to form a pattern while said stage is moving, said pattern being divided into plurality of fields each of which is further divided into a plurality of subfields, said system comprising :

a central control unit operable to control operation of the system ;

a stage for carrying a substrate to be exposed to said charged particle beam, said stage being movable in X and Y directions ;

a main deflector operated by a main deflecting signal for deflecting said charged particle beam to a subfield ;

a subdeflector for deflecting said charged particle beam to a position (x, y) in said subfield in response to a pair of pattern signals x/y respectively controlling the deflection of the electron beam in X and Y directions ;

a pattern generator for generating said pair of pattern signals x, y, which are signals which would lead to generation of a corresponding part of said pattern on said subfield were the stage not moving, and sending said pattern signals to said subdeflector ;

stage controller means for moving said stage in X and Y directions under the command of said central control unit ;

a stage detector means for detecting the position and velocity of said stage in real time and sending out position data describing the position of said stage, and distance data $\Delta_x$, $\Delta_y$ respectively corresponding to the distance of movement of said stage in X and Y directions over a time period extending from the instant at which the charged particle beam was last deflected by the main deflector to the present instant, and velocity data $V_x$, $V_y$ describing the velocity of said stage ; and

correction generator means for generating a correction signal for correcting the effect of movement of the stage and compensating the eddy current effect, said correction generator comprising :

a distance data adder for respectively adding said distance data $\Delta_x$ and $\Delta_y$ to said pattern signals x, y ;

register means for storing proportional constants A, B, C and D ;

a set of first multipliers for respectively multiplying the velocity data $V_x$ by said proportional constants A and C ;

a set of second multipliers for respectively multiplying the velocity data $V_y$ by said proportional constant B and D ;

a set of first adders for respectively adding the outputs of said first multiplier and second multiplier ; and

a set of second adders for respectively adding the outputs of said distance data adder and said first adder.

5. A charged particle beam exposure system according to claim 4, wherein said proportional constants are determined by the relationships :

$$\delta x = A.V_x + B.V_y$$
$$\delta y = C.V_x + D.V_y$$

where $\delta x$ and $\delta y$ are respectively the shift distance of the charged particle beam position in X or Y directions from a first position when said stage is not moving to a second position when the stage is moving with velocity components $V_x$ and $V_y$ in X and Y directions.

**Patentansprüche**

1. Verfahren zur Kompensation von Wirbelstromeffekten in einem Ladungsteilchenstrahl-Belichtungssystem aufgrund eines Leckflusses von einer magnetischen Linse des Systems und der Bewegung einer Bühne des Systems, die ein Substrat trägt, auf welches ein fokussierter Ladungsteilchenstrahl eingestrahlt wird, während die genannte Bühne sich bewegt, und der genannte Strahl durch Mustersignale x, y in X- und Y-Richtungen abgelenkt wird, um den Strahl zu einer Position (x, y) von einem Muster abzulenken, welches Verfahren die folgenden Schritte umfaßt :

(a) Bestimmen von Proportionalitätskonstanten zwischen der Abweichung des geladenen Teilchenstrahls, die durch die Wirbelströme und die Geschwindigkeit der Bühne verursacht wird ;

(b) Erzeugen eines Korrektursignals, welches ein negatives Produkt der Geschwindigkeit der Bühne und der genannten Proportionalkonstanten ist ; und

(c) Überlagern des genannten Korrektursignals über das genannte Mustersignal, um so die genannte Abweichung des Ladungsteilchenstrahles zu korrigieren.

2. Verfahren nach Anspruch 1, bei dem die genannten Proportionalitätskonstanten vier Konstanten A, B, C und D umfassen, die durch die folgenden Relationen bestimmt sind :

$$\delta x = A.V_x + B.V_y \quad (1)$$
$$\delta y = C.V_x + D.V_y \quad (2)$$

wobei $\delta x$, $\delta y$ die Verschiebungen des Ladungsteilchenstrahlpunktes aufgrund der Wirbelströme jeweils in X- bzw. Y-Richtung auf dem genannten Substrat sind, und $V_x$, $V_y$ die Geschwindigkeitskomponenten der genannten Bühne in X- bzw. Y-Richtung sind, und der genannte Schritt (a) die folgenden Schritte umfaßt :

(a-1) Unterstützen des Testsubstrates, welches ein Testmuster hat, in einer Position parallel zu der oberen Oberfläche der genannten Bühne und möglichst nahe jedoch getrennt von der genannten Bühne, so daß das genannte Testsubstrat relativ zu den genannten magnetischen Linsen des genannten Ladungsteilchenstrahl-Belichtungssystems fixiert ist, unabhängig von der Bewegung der genannten Bühne ;

(a-2) Zeigen eines Bildes des genannten Testmusters auf einer Kathodenstrahlröhre durch Abtastelektronenmodusbetrieb des genannten Ladungsteilchen-Belichtungs-systems ;

(a-3) Bewegen der genannten Bühne in X- oder Y-Richtung mit einer konstanten Geschwindigkeit $V_x$ bzw. $V_y$ ; und

(a-4) Bestimmen der Werte von $\delta x$ und $\delta y$ in den genannten Gleichungen (1) und (2) aus der Verschiebung des genannten Bildes von einer ersten Bildposition, wenn die Bühne sich nicht bewegt, zu einer zweiten Bildposition, wenn die Bühne sich bewegt.

3. Ladungsteilchenstrahl-Belichtungssystem, bei dem die Wirbelstromeffekte aufgrund eines Leckflusses von einer magnetischen Linse des Systems und der Bewegung einer Bühne des Systems, die ein Substrat trägt, auf welches ein fokussierter Ladungsteilchenstrahl eingestrahlt wird, während die genannte Bühne sich bewegt, kompensiert werden, welches System umfaßt :

Ablenkeinrichtungen zum Ablenken des genannten Ladungsteilchenstrahls in Übereinstimmung mit einem Muster, mittels Mustersignalen ;

Detektionseinrichtungen zum Detektieren der Positon und Geschwindigkeit der genannten Bühne in Echtzeit, und Aussenden von Positionsdaten und Geschwindigkeitsdaten ;

Speichereinrichtungen, die Proportionalitätskonstanten zwischen der Abweichung des Ladungsteilchenstrahls, die durch Wirbelstromeffekte und die Geschwindigkeit der Bühne verursacht werden, speichern ;

Korrekturgeneratoreinrichtungen, zum Generieren von Korrektursignalen, die ein negatives Produkt der genannten Proportionalitätskonstanten und der genannten Geschwindigkeitsdaten sind ;

Rückkopplungseinrichtungen, zum Rückkoppeln der genannten Korrektursignale zu der genannten Ablenkeinrichtung.

4. Ladungsteilchenstrahl-Belichtungssystem, bei dem eine Kompensation für Wirbelstromeffekte aufgrund eines Leckflusses von einer magnetischen Linse des Systems und der Bewegung einer Bühne des Systems, die ein Substrat trägt, auf welches ein fokussierter Ladungsteilchenstrahl eingestrahlt wird, vorgesehen ist, welcher Strahl in X- und Y-Richtungen abgelenkt wird, um ein Muster zu formen, während die Bühne sich bewegt, welches genannte Muster in eine Vielzahl von Feldern unterteilt wird, von denen jedes weiter in eine Vielzahl von Unterfeldern unterteilt ist, welches System umfaßt :

eine zentrale Steuereinheit, die betreibbar ist, um den Betrieb des Systems zu steuern ;

eine Bühne zum Tragen eines Substrats, das dem genannten Ladungsteilchenstrahl exponiert werden soll, welche Bühne in X- und Y-Richtungen bewegbar ist ;

einen Hauptdeflektor, der von einem Hauptablenksignal betrieben wird, um den genannten Ladungsteilchenstrahl zu einem Unterfeld abzulenken ;

einen Subdeflektor, um den genannten Ladungsteilchenstrahl zu einer Position (x, y) in dem genannten Unterfeld in Abhängigkeit von einem Paar von Signalen x bzw. y abzulenken, welche die Ablenkung des Elektronenstrahls in X- und Y-Richtungen steuern ;

einem Mustergenerator zum Generieren des genannten Paares von Mustersginalen x, y, welches Signale sind, die zu einer Erzeugung eines entsprechenden Teils des genannten Musters auf dem genannten Unterfeld führen würden, würde die Bühne nicht bewegt, und Senden der genannten Mustersignale zu dem genannten Subdeflektor ;

Bühnensteuereinrichtungen, zum Bewegen der genannten Bühne in X- und Y-Richtungen, unter dem Befehl der genannten zentralen Steuereinheit ;

einer Bühnendetektoreinrichtung zum Detektieren der Position und Geschwindigkeit der genannten Bühne in Echtzeit und zum Aussenden von Positionsdaten, die die Position der genannten Bühne beschreiben, und von Abstanddaten $\Delta x$ bzw. $\Delta y$, die dem Abstand der Bewegung der genannten Bühne in X- und Y-Richtungen entsprechen, über eine Zeitperiode, die sich von dem Augenblick erstreckt, zu welchem der Ladungsteilchenstrahl zum letzten mal von dem Hauptdeflektor abgelenkt wurde, bis zum gegenwärtigen Augenblick, und von Geschwindigkeitsdaten $V_x$, $V_y$, welche die Geschwindigkeit der genannten Bühne beschreiben ; und

Korrekturgeneratoreinrichtungen zum Generieren eines Korrektursignals zum Korrigieren der Wirkung der Bewegung der Bühne und zum Kompensieren des Wirbelstromeffektes, welcher Korrekturgenerator umfaßt :

einen Abstandsdatenaddierer, um jeweils die Abstandsdaten $\Delta x$ bzw. $\Delta y$ zu den genannten Mustersignalen x, y zu addieren ;

Registereinrichtungen zum Speichern von Proportionalitätskonstanten A, B, C und D ;

einen Satz von ersten Multiplizierern, um jeweils die Geschwindigkeitsdaten $V_x$ mit den genannten Proportionalitätskonstanten A bzw. C zu multiplizieren ;

einen Satz von zweiten Multiplizierern, um jeweils die Geschwindigkeitsdaten $V_x$ mit den genannten Proportionalitätskonstanten B bzw. D zu multiplizieren ;

einen Satz von ersten Addierern, um jeweils die Ausgänge des genannten ersten Multiplizierers und des genannten zweiten Multiplizierers zu addieren ; und

einen Satz von zweiten Addierern, um jeweils die Ausgänge des genannten Abstandsdatenaddierers und des genannten ersten Addierers zu addieren.

5.      Ladungsteilchenstrahl-Belichtungssystem nach Anspruch 4, bei dem die genannten Proportionalitätskonstanten durch die folgenden Relationen bestimmt sind :

$$\delta x = A.V_x + B.V_y$$
$$\delta y = C.V_x + D.V_y$$

wobei $\delta x$ und $\delta y$ der Verschiebungsabstand der Ladungsteilchenposition in X- bzw. Y-Richtung von einer ersten Position sind, wenn die Bühne sich nicht bewegt, in eine zweite Position, wenn die Bühne sich mit Geschwindigkeitskomponenten $V_x$ und $V_Y$ in X- und Y-Richtungen bewegt.

## Revendications

1. Procédé permettant de compenser les effets de courants parasites de Foucault dans un système d'exposition à un faisceau de particules chargées qui sont dus aux fuites de flux d'une lentille magnétique du système et au déplacement d'un plateau de support du système portant un substrat sur lequel un faisceau de particules chargées mis au point est envoyé tandis que ledit plateau de support se déplace et ledit faisceau est dévié suivant les directions X et Y par des signaux de motif x et y servant à faire dévier le faisceau jusqu'à une position (x, y) d'un motif, ledit procédé comprenant les opérations suivantes :

(a) déterminer les constantes de proportionnalité entre l'écart du faisceau de particules chargées dû aux courants parasites de Foucault et la vitesse du plateau de support ;

(b) produire un signal de correction qui est la forme négative du produit de la vitesse du plateau de support par lesdites constantes de proportionnalité ; et

(c) superposer ledit signal de correction audit signal de motif, afin de corriger ledit écart du faisceau de particules chargées.

2. Procédé selon la revendication 1, où lesdites constantes de proportionnalité comprennent quatre constantes A, B, C et D, qui sont déterminées par les relations suivantes :

$$\delta x = A.V_x + B.V_y \quad (1)$$
$$\delta y = C.V_x + D.V_y \quad (2)$$

où δx et δy sont respectivement les décalages de la tache du faisceau de particules chargées qui sont dus aux courants parasites de Foucault suivant les directions X et Y sur ledit substrat, et $V_x$ et $V_y$ sont respectivement les composantes de vitesse dudit plateau de support suivant les directions X et Y, ladite opération (a) comprenant les opérations suivantes :

(a-1) soutenir un substrat d'essai, qui possède un motif d'essai, en une position parallèle à la surface supérieure dudit plateau de support et aussi près que possible de celui-ci tout en en restant séparé, de façon que ledit substrat d'essai soit fixe par rapport à ladite lentille magnétique dudit système d'exposition à un faisceau de particules chargées, indépendamment du déplacement dudit plateau de support ;

(a-2) représenter l'image dudit motif d'essai sur un tube à rayons cathodiques en faisant fonctionner ledit système d'exposition à un faisceau de particules chargées suivant un mode de microscope électronique à balayage ;

(a-3) faire déplacer ledit plateau de support dans la direction X ou Y avec une vitesse constante $V_x$ ou $V_y$ respective ; et

(a-4) déterminer la valeur de δx et δy desdites équations (1) et (2) à partir du décalage de ladite image entre une première position d'image, où le plateau de support ne se déplace pas, et une deuxième position d'image, où le plateau de support se déplace.

3. Système d'exposition à un faisceau de particules chargées, dans lequel les effets de courants parasites de Foucault dus à des fuites de flux d'une lentille magnétique du système et au déplacement d'un plateau de support du système portant un substrat sur lequel un faisceau de particules chargées mis au point est envoyé tandis que ledit plateau de support se déplace sont compensés, ledit système comprenant :

un moyen de déviation servant a dévier ledit faisceau de particules chargées en fonction d'un motif, par l'intermédiaire de signaux de motif ;

un moyen de détection servant à détecter la position et la vitesse dudit plateau de support en temps réel, et à délivrer des données de position et des données de vitesse ;

un moyen de mémorisation qui emmagasine des constantes de proportionnalité entre l'écart du faisceau de particules chargées provoqué par les courants parasites de Foucault et la vitesse du plateau de support ;

un moyen générateur de correction servant à produire des signaux de correction qui sont la forme négative du produit desdites constantes de proportionnalité et desdites données de vitesse ; et

un moyen de réaction servant à renvoyer, en réaction, lesdits signaux de correction audit moyen de déviation.

4. Système d'exposition à un faisceau de particules chargées, dans lequel une compensation est réalisée pour les effets de courants parasites de Foucault dus aux fuites de flux d'une lentille magnétique du système et au déplacement d'un plateau de support du système portant un substrat sur lequel un faisceau de particules chargées mis au point est envoyé, ledit faisceau étant dévié suivant les directions X et Y de façon à former un motif pendant que ledit plateau de support se déplace, ledit motif étant divisé en plusieurs zones qui sont chacune divisées en outre en plusieurs sous-zones, ledit système comprenant :

une unité centrale de commande ayant pour fonction de commander le fonctionnement du système ;

un plateau de support servant à porter un substrat devant être exposé audit faisceau de particules chargées, ledit plateau de support étant mobile suivant les directions X et Y ;

un dispositif principal de déviation fonctionnant sous commande d'un signal principal de déviation servant à faire dévier ledit faisceau de particules chargées jusqu'à une sous-zone ;

un dispositif secondaire de déviation servant à faire dévier ledit faisceau de particules chargées jusqu'à une position (x, y) située dans ladite sous-zone en réponse à une paire de signaux de motif x et y commandant respectivement la déviation du faisceau électronique dans les directions X et Y ;

un générateur de motif servant à produire ladite paire de signaux de motif x et y, lesquels sont les signaux qui conduiraient à la production d'une partie correspondante dudit motif sur ladite sous-zone si le plateau de support ne se déplaçait pas, et à envoyer lesdits signaux de motif audit dispositif secondaire de déviation ;

un moyen de commande de plateau de support servant à déplacer ledit plateau de support suivant les directions X et Y sous commande d'instructions venant de ladite unité centrale de commande ;

un moyen détecteur de plateau de support servant à détecter la position et la vitesse dudit plateau de support en temps réel et à délivrer des données de position décrivant la position dudit plateau de support et des données de distance Δx et Δy correspondant respectivement à la distance de déplacement dudit plateau de support suivant les directions X et Y au cours d'une durée allant de l'instant où le faisceau de particules chargées a été dévié pour la dernière fois par le dispositif principal de déviation jusqu'à l'instant courant, ainsi que des données de vitesse $V_x$ et $V_y$ décrivant la vitesse dudit plateau de support ; et

un moyen générateur de correction servant à produire un signal de correction permettant de corriger l'effet du déplacement du plateau de support et de compenser l'effet des courants parasites de Foucault, ledit générateur de correction comprenant :

un additionneur de données de distance servant à respectivement additionner lesdites données de distance $\Delta x$ et $\Delta y$ auxdits signaux de motif x et y ;

des moyens constituant des registres qui servent à mémoriser des constantes de proportionnalité A, B, C et D ;

un groupe de premiers multiplicateurs servant à respectivement multiplier la donnée de vitesse $V_x$ par lesdites constantes de proportionnalité A et C ;

un groupe de deuxièmes multiplicateurs servant à respectivement multiplier la donnée de vitesse $V_y$ par lesdites constantes de proportionnalité B et D ;

un groupe de premiers additionneurs servant à respectivement additionner les signaux de sortie desdits premiers multiplicateurs et deuxièmes multiplicateurs respectifs ; et

un groupe de deuxièmes additionneurs servant à respectivement additionner les signaux de sortie dudit additionneur de données de distance et desdits premiers additionneurs respectifs.

5. Système d'exposition à un faisceau de particules chargées selon la revendication 4, où lesdites constantes de proportionnalité sont déterminées par les relations suivantes :

$$\delta x = A.V_x + B.V_y$$
$$\delta y = C.V_x + D.V_y$$

où $\delta x$ et $\delta y$ sont respectivement les distances de décalage de la position du faisceau de particules chargées suivant les directions X et Y entre une première position, où ledit plateau de support ne se déplace pas, et une deuxième position, où le plateau de support se déplace avec des composantes de vitesse $V_x$ et $V_y$ suivant les directions X et Y.

# FIG. 1 (a)

# FIG. 1 (b)

# FIG. 2

FIG. 3

EP 0 307 906 B1

*FIG. 4*

## FIG. 5

## FIG. 6